# EUROPEAN PATENT SPECIFICATION

(11) **EP 4 315 441 B1**
(45) Date of publication and mention of the grant of the patent: **14.05.2025**
(21) Application number: 22718201.1
(22) Date of filing: 25.03.2022
(51) Int. Cl.: H10N 30/85, H10N 30/857, H10N 30/01, H10N 30/092, H10N 30/098

(54) **PIEZOELECTRIC COMPOSITES HAVING COATED PIEZOELECTRIC FILLERS**
PIEZOELEKTRISCHE VERBUNDWERKSTOFFE MIT BESCHICHTETEN PIEZOELEKTRISCHEN FÜLLSTOFFEN
COMPOSITES PIÉZOÉLECTRIQUES DOTÉS DE CHARGES PIÉZOÉLECTRIQUES REVÊTUES

(30) Priority: 30.03.2021 EP 21166035
(43) Date of publication of application: 07.02.2024
(73) Proprietor: SABIC Global Technologies B.V., 4612 PX Bergen op Zoom (NL)
(72) Inventor: GUHATHAKURTA, Soma, Bangalore 562125 (IN); HOEKS, Theodorus Lambertus, Bangalore 562125 (IN); MAHON, Tadhg, Bangalore 562125 (IN)
(74) Representative: IPecunia
(86) International application number: PCT/EP2022/057985
(87) International publication number: WO 2022/207504

(56) References cited:
- WO-A1-2020/201922
- US-A1- 2020 303 621
- DEUTZ D. B. ET AL: "Poling piezoelectric (K,Na,Li)NbO 3 -polydimethylsiloxane composites", vol. 515, no. 1, 27 July 2017 (2017-07-27), US, pages 68 - 74, XP055836895, ISSN: 0015-0193, Retrieved from the Internet <URL:https://www.tandfonline.com/doi/pdf/10.1080/00150193.2017.1360110> DOI: 10.1080/00150193.2017.1360110

## Description

### CROSS REFERENCE TO RELATED APPLICATIONS

None.

### FIELD OF INVENTION

The present invention is directed to the field of piezoelectric composite having polymer coated piezoelectric fillers and in particular to films containing such piezoelectric composite.

### BACKGROUND

Piezoelectric elements find application in a variety of electro-mechanical devices such as resonators, sensors, buzzers, transducers, ultrasonic receivers and generators. As a result, in recent years there has been a sharp increase in the demand for such piezoelectric elements with several industry practitioners looking at improving the performance of the piezoelectric elements. Traditionally, one of the criteria for a suitable piezoelectric material is to have a balance of low dielectric loss (denoted by (tan δ)) while retaining a sufficiently high piezoelectric charge coefficient (d₃₃). A material with high piezoelectric charge coefficient (d₃₃) is indicative of its excellent piezoelectric property and signifies the development of suitable electric potential, when a mechanical stress is applied to the material.

On the other hand, dielectric loss (denoted by (tan δ)) in piezoelectric materials, is indicative of energy loss in the form of heat, when a piezoelectric material is used in electro-mechanical devices. Dielectric loss causes internal heating in electro-mechanical devices, affecting both performance efficiency as well as long term durability of such electro-mechanical devices. In other words, minimizing dielectric loss would render the piezoelectric material to be more efficient in its performance. Yet another consideration has been to obtain piezoelectric materials that have low dielectric constant or low relative permittivity for certain application. Relative permittivity determines the ability of a material to polarize in response to an applied electric field. It is often preferred to have a material whose relative permittivity is low so as to enable the piezoelectric material to have a high piezoelectric voltage constant (g), and rendering such materials to have improved sensing performance.

Further, it has been observed in few instances that high relative permittivity, may cause dielectric loss to increase, which affects both output and performance efficiency of a device (e.g. an actuator). Therefore, for a piezoelectric material, a suitable balance of piezoelectric charge coefficient (d₃₃), relative permittivity and dielectric loss (tan δ), would provide the desired piezoelectric performance suited for sensing applications.

However, it has been reported in several research publications, that the performance of piezoelectric material is particularly susceptible to fluctuation in a high moisture environment, as has been reported in several publications such as (i) Hagh et. Al Property-processing relationship in lead-free (K, Na, Li) NbO, 3-solid solution system, J. Electroceramics. 18 (2007) 339-346*, (ii)* Y.H. Gu et.al, Water-induced degradation in (Bi 1/2Na 1/2)TiO 3 lead-free ceramics, J. Electron. Mater. 38 (2009) 2207-2210*.* In fact, it has been observed by industry practitioners that in certain instances piezoelectric materials, upon exposure to high moisture environment, experience increased dielectric loss (tan δ), which in turn adversely affects the performance of an electro-mechanical device. As described in the patent US5475278A, direct exposure of a piezoelectric material to moisture can damage a device, where moisture on contact with the piezo material, may induce unwarranted electrical discharge or short circuiting. In the past, surface functionalized piezoelectric materials have been used to shield the piezoelectric material from direct moisture contact. However, such technical solutions have had limited success. The patent US2020/303621 A1 illustrates a polymeric piezoelectric composite comprising a polymer matrix formed from one or more of a monomer or a precursor polymer; and an in-situ dispersion of a piezoelectric ceramic filler and an ionic additive within the polymer matrix. The patent WO2020/201922 A1 concerns a lead-free piezoelectric composite that includes a polymeric matrix. The polymeric matrix (preferably a PVDF-based copolymer like PVDF-TrFE-CFE terpolymer) is loaded with greater than 10 vol.% of lead-free piezoelectric particles. The publication in the Journal Ferroelectrics 2017, vol. 515, pg. 68-74, https:// doi.org/10.1080/00150193.2017.1360110 titled "Poling piezoelectric (K,Na,Li)NbO3-polydimethylsiloxane composites" by D.B. Deutz et al discloses composites of aligned (K,Na,Li)NbO₃ (KNLN) piezoceramic particles in a PDMS polymer matrix.

Thus, for the foregoing reasons, there remains a need for developing piezoelectric materials that demonstrate low dielectric loss (tan δ) even when such piezoelectric materials are exposed to humid conditions or high moisture environment. In particular, there is a need to develop piezoelectric materials that demonstrate a desired balance of low dielectric loss (tan δ) and suitable piezoelectric charge coefficient (d₃₃), even when such materials are exposed to humid environment.

### BRIEF SUMMARY

The invention relates to a piezoelectric composite, comprising: (a) a polymer matrix; and (b) a plurality of coated piezoelectric filler particles, wherein each of the plurality of coated piezoelectric filler particles is dispersed in the polymer matrix, and further wherein each of the plurality of coated piezoelectric filler particles comprises a piezoelectric material having at least a portion of its outer surface coated with a polymeric material having at least one polar functional group.

In some embodiments of the invention, the polymeric material comprises at least one polar functional group selected from hydroxyl group, carboxylate group, ester group, sulfonic acid group, amide group, siloxane group, amino group, sulfhydryl, phosphate, ether group, halogen group, and a nitrile group.

In some embodiments of the invention, the plurality of coated piezoelectric filler particles are present in an amount ≥ 20.0 volume% and ≤ 80.0 volume%, with regard to the total volume of the piezoelectric composite.

In some embodiments of the invention, the piezoelectric material is selected from hydroxyapatite, apatite, lithium sulfate monohydrate, sodium bismuth titanate, quartz, tartaric acid, poly(vinylidene difluoride), barium titanate, potassium sodium niobate (KNaNb)O₃ (KNN), lead zirconate titanate (PZT), lead niobium titanate (PNT), lead scandium niobium titanate (PSNT), lead metaniobate, lithium doped potassium sodium niobate (KNLN) represented by the formula (K_{0.5}Na_{0.5})₁₋ₜLiₜNbO₃, wherein the variable 't' ranges from greater than 0.01 to less than 1.0 (0.01<t<1.00).

In some embodiments of the invention, the polymeric material is selected from polydimethylsiloxane (PDMS), polyvinylpyrrolidone (PVP), grafted polyolefins, acrylate and methacrylate polymers, polyethylene glycol, vinyl acetate polymers polycarbonate, vinylidene fluoride (VDF) polymers, cyano polymers, poly(phenylene oxide) or combinations thereof.

Preferably, in some embodiments of the invention, the polymeric material is selected from polydimethylsiloxane (PDMS), polyvinylpyrrolidone (PVP), grafted polyolefins, polyethylene glycol, vinyl acetate polymers, cyano polymers, or combinations thereof. More preferably, in some embodiments of the invention, the polymeric material is selected from polydimethylsiloxane (PDMS), or polyvinylpyrrolidone (PVP).

In some embodiments of the invention, the polymeric material is selected from polyvinylpyrrolidone (PVP) or polydimethylsiloxane (PDMS) and the piezoelectric material is a lithium doped potassium sodium niobate (KNLN) represented by the formula (K_{0.5}Na_{0.5})₁₋ₜLiₜNbO₃ wherein 't' is 0.03 (KNLN3) or 't' is 0.06 (KNLN6).

In some embodiments of the invention, the polymeric material is polyvinylpyrrolidone (PVP) and the piezoelectric material is a lithium doped potassium sodium niobate (KNLN) represented by the formula (K_{0.5}Na_{0.5})₁₋ₜLiₜNbO₃ wherein 't' is 0.03 (KNLN3) or 't' is 0.06 (KNLN6).

In some embodiments of the invention, the polymeric material is polydimethylsiloxane (PDMS) and the piezoelectric material is a lithium doped potassium sodium niobate (KNLN) represented by the formula (K_{0.5}Na_{0.5})₁₋ₜLiₜNbO₃ wherein 't' is 0.03 (KNLN3) or 't' is 0.06 (KNLN6).

According to the invention, the polymer matrix and the polymeric material coating of piezoelectric material are of different polymer composition.

In some embodiments of the invention, the polymer matrix is a polymer selected from vinylidene fluoride (VDF) polymer, polycaprolactone, polysiloxane, polydimethylsiloxane (PDMS), polyolefin co-polymers, polysiloxane-polycarbonate copolymers, acrylate and/or methacrylate copolymers, polyethylene terephthalate (PET), polycarbonate (PC), polybutylene terephthalate (PBT), poly(1,4-cyclohexylidene cyclohexane-1,4-dicarboxylate) (PCCD), glycol modified polycyclohexyl terephthalate (PCTG), poly(phenylene oxide) (PPO), polypropylene (PP), polyethylene (PE), polyvinyl chloride (PVC), polystyrene (PS), polyethyleneimine or polyetherimide (PEI) and their derivatives, thermoplastic elastomer (TPE), terephthalic acid (TPA) polymers, poly(cyclohexanedimethylene terephthalate) (PCT), polyethylene naphthalate (PEN), polyamide (PA), polysulfone sulfonate (PSS), sulfonates of polysulfones, polyether ether ketone (PEEK), acrylonitrilebutadiene styrene (ABS), polyether ketone ketone (PEKK), polyphenylene sulfide (PPS), or blends or combinations thereof.

Preferably, the polymer matrix is a polymer selected from vinylidene fluoride (VDF) polymer, polycaprolactone, polyolefin co-polymers, polysiloxane-polycarbonate copolymers, acrylate and/or methacrylate copolymers, polyethylene terephthalate (PET), polycarbonate (PC), polybutylene terephthalate (PBT), poly(1,4-cyclohexylidene cyclohexane-1,4-dicarboxylate) (PCCD), glycol modified polycyclohexyl terephthalate (PCTG), poly(phenylene oxide) (PPO), polypropylene (PP), polyethylene (PE), polyvinyl chloride (PVC), polystyrene (PS), polyethyleneimine or polyetherimide (PEI) and their derivatives, terephthalic acid (TPA) polymers, poly(cyclohexanedimethylene terephthalate) (PCT), polyethylene naphthalate (PEN), polyamide (PA), polysulfone sulfonate (PSS), sulfonates of polysulfones, polyether ether ketone (PEEK), acrylonitrilebutadiene styrene (ABS), polyether ketone ketone (PEKK), polyphenylene sulfide (PPS), or blends or combinations thereof.

More preferably, the polymer matrix is a polymer selected from vinylidene fluoride (VDF) polymer.

In some embodiments of the invention, the polymer matrix is a vinylidene fluoride (VDF) polymer selected from polyvinylidene fluoride (PVDF), polyvinylidene fluoride-co-tri-fluoroethylene (PVDF-TrFE), poly(vinylidene fluoride-co-hexafluoropropylene)(PVDF-HFP), polyvinylidene fluoride-co-tetrafluoro ethylene (PVDF-TFE), poly(vinylidene fluoride-co-trifluoroethylene-co-chlorofluoroethylene) (PVDF-TrFE-CFE),poly(vinylidene-fluoride-co-trifluoroethylene-co- chlorotrifluoroethylene)(PVDF-TfFE-CTFE) or combinations thereof. Preferably, in some embodiments of the invention, the polymer matrix is a vinylidene fluoride (VDF) polymer selected from poly(vinylidene fluoride-co-trifluoroethylene-co-chlorofluoroethylene) (PVDF-TrFE-CFE), or polyvinylidene fluoride-co-tri-fluoroethylene (PVDF-TrFE).

In some embodiments of the invention, the piezoelectric composite comprises:
a. ≥ 20.0 volume % and ≤ 80.0 volume %, preferably ≥ 30.0 volume % and ≤ 55.0 volume %, with regard to the total volume of the piezoelectric composite, of the polymer matrix wherein the polymer matrix comprises a polymer selected from poly(vinylidene fluoride-co-trifluoroethylene-co-chlorofluoroethylene) (PVDF-TrFE-CFE) or polyvinylidene fluoride- co-tri-fluoroethylene (PVDF-TrFE); and
b. ≥ 20.0 volume % and ≤ 80.0 volume %, preferably ≥ 30.0 volume % and ≤ 55.0 volume %, with regard to the total volume of the piezoelectric composite, of the plurality of coated piezoelectric filler particles dispersed in the polymer matrix, wherein each of the plurality of coated piezoelectric filler particles comprises a piezoelectric material comprising lithium doped potassium sodium niobate (KNLN) represented by the formula (K_{0.5}Na_{0.5})₁₋ₜLiₜNbO₃ wherein 't' is 0.03 (KNLN3) or 't' is 0.06 (KNLN6) and wherein each of the piezoelectric material is coated with a polymeric material selected from polyvinylpyrrolidone (PVP) or polydimethylsiloxane (PDMS).

In a preferred aspect of the invention, the invention is directed to a film comprising the piezoelectric composite of the present invention. In yet another aspect of the present invention, the invention is directed to an article of manufacture comprising a film, wherein the film comprises the piezoelectric composite of the present invention.

In some embodiments of the invention, the invention relates to the use of the film comprising the piezoelectric composite of the present invention, for improving the piezoelectric property of the article of manufacture. Non-limiting examples of piezoelectric property includes piezoelectric charge coefficient (d₃₃), relative permittivity and dielectric loss (tan δ).

In some aspects of the invention, the invention is directed to a method for preparing a film comprising the piezoelectric composite of the present invention, wherein the method comprises:
a. dissolving a polymer in an organic solvent and forming a polymer solution;
b. adding a plurality of coated piezoelectric filler particles to the polymer solution and forming a precursor piezoelectric composite solution;
c. casting the precursor piezoelectric composite solution on a substrate and forming a precursor film; and
d. subjecting the precursor film to an electric polarization treatment and forming the film.

In some embodiments of the invention, the precursor film comprises the piezoelectric composite. In some aspects of the invention, the precursor film comprises ≥ 99.0 wt.%, preferably ≥ 99.5 wt.%, preferably 100.0 wt.%, of the piezoelectric composite, with regard to the total weight of the precursor film.

In some embodiments of the invention, the electric polarization treatment is conducted at an electric field ≥ 5 KV/mm and ≤ 100 KV/mm for a time period ≥ 1 minute and ≤ 120 minutes and at a temperature ≥ 50 °C and ≤ 120 °C, preferably at a temperature ≥ 60 °C and ≤ 110 °C.

In some embodiments of the invention, the invention, is directed to a film comprising the piezoelectric composite, wherein the film is obtained by a method comprising:
a. dissolving a polymer in an organic solvent and forming a polymer solution;
b. adding a plurality of coated piezoelectric filler particles to the polymer solution and forming a precursor piezoelectric composite solution;
c. casting the precursor piezoelectric composite solution on a substrate and forming a precursor film; and
d. subjecting the precursor film to an electric polarization treatment and forming the film.

Other objects, features and advantages of the present invention will become apparent from the following figures, detailed description, and examples. It should be understood, however, that the figures, detailed description, and examples, while indicating specific embodiments of the invention, are given by way of illustration only and are not meant to be limiting. In further embodiments, features from specific embodiments may be combined with features from other embodiments. For example, features from one embodiment may be combined with features from any of the other embodiments. In further embodiments, additional features may be added to the specific embodiments described herein.

### BRIEF DESCRIPTION OF THE DRAWINGS

For a more complete understanding, reference is now made to the following descriptions taken in conjunction with the accompanying drawings, in which:
FIG. 1 (a) is a Scanning Electron Microscopy (SEM) image of a precursor film cross section containing uncoated (KNLN3) piezoelectric filler particles dispersed in a poly(vinylidene fluoride-co-trifluoroethylene-co-chlorofluoroethylene) (PVDF-TrFE-CFE) polymer matrix.
FIG. 1 (b) is a Scanning Electron Microscopy (SEM) image of a precursor film cross section containing polyvinylpyrrolidone (PVP) coated (KNLN3) piezoelectric filler particles piezoelectric filler particles dispersed in a poly(vinylidene fluoride-co-trifluoroethylene-co-chlorofluoroethylene) (PVDF-TrFE-CFE) polymer matrix and in accordance with Example 2.
FIG. 2 (a) is a Scanning Electron Microscopy (SEM) image of a precursor film cross section containing 3-aminopropylmethyldiethoxysilane (ADS) functionalized (KNLN3) piezoelectric filler particles dispersed in a poly(vinylidene fluoride-co-trifluoroethylene-co-chlorofluoroethylene) (PVDF-TrFE-CFE) polymer matrix in accordance with Example 4.
FIG. 2 (b) is a Scanning Electron Microscopy (SEM) image of a precursor film cross section containing (3-mercaptopropyl) methyldimethoxysilane (MPMDS) functionalized (KNLN3) piezoelectric filler particles dispersed in a poly(vinylidene fluoride-co-trifluoroethylene-co-chlorofluoroethylene) (PVDF-TrFE-CFE) polymer matrix and in accordance Example 5.
FIG. 3 is a Fourier Transformed Infrared spectrograph (FT-IR) indicating the spectrograph signal for the 1) uncoated KNLN3 powder, 2) of the isolated PVP coating, and 3) of the KNLN3 powder after being coating with PVP.
FIG. 4 (a) is a Scanning Electron Microscopy (SEM) image of an uncoated piezoelectric filler particle KNLN3.
FIG. 4 (b) is a Scanning Electron Microscopy (SEM) image of a poly(dimethyl siloxane) (PDMS) coated piezoelectric filler particle KNLN3.
FIG. 4 (c) is a Scanning Electron Microscopy (SEM) image of a precursor film cross section comprising an uncoated KNLN3 piezoelectric filler particles dispersed in a polyvinylidene fluoride-co-tri-fluoroethylene (PVDF-TrFE) polymer matrix.
FIG. 4 (d) is a Scanning Electron Microscopy (SEM) image of a precursor film cross section comprising poly(dimethyl siloxane) (PDMS) coated KNLN3 piezoelectric filler particles dispersed in a polyvinylidene fluoride-co-tri-fluoroethylene (PVDF-TrFE) polymer matrix and in accordance with Example 3.

### DETAILED DESCRIPTION

A solution to some or all of the drawbacks in existing art, resides in a piezoelectric composite as described in this disclosure. Accordingly, the invention, is based, in part, on a piezoelectric composite comprising a polymer matrix containing a plurality of polymer coated piezoelectric filler particles dispersed in the polymer matrix.

Advantageously, the piezoelectric composite or a film comprising such a composite, demonstrates a suitable piezoelectric property having a low dielectric loss (tan δ) while retaining a suitable piezoelectric charge coefficient (d₃₃). In particular, the invention now enables a skilled artisan to make devices or articles of manufacture comprising such a film, which demonstrate excellent piezoelectric performance even when operating such devices or articles in humid conditions.

The following includes definitions of various terms and phrases used throughout this specification.

The terms "wt.%", "volume %" or "mol.%" refers to a weight, volume, or molar percentage of a component, respectively, based on the total weight, the total volume, or the total moles of the material that includes the component. Any numerical range used throughout this disclosure shall include all values and ranges there between unless specified otherwise. For example, a boiling point range of 50 °C to 100 °C includes all temperatures and ranges between 50 °C and 100 °C including the temperature of 50 °C and 100 °C.

The use of the words "a" or "an" when used in conjunction with the term "comprising," "including," "containing," or "having" in the claims or the specification may mean "one," but it is also consistent with the meaning of "one or more," "at least one," and "one or more than one." The words "comprising" (and any form of comprising, such as "comprise" and "comprises"), "having" (and any form of having, such as "have" and "has"), "including" (and any form of including, such as "includes" and "include") or "containing" (and any form of containing, such as "contains" and "contain") are inclusive or open-ended and do not exclude additional, unrecited elements or method steps. The process of the present invention can "comprise", "consist essentially of," or "consist of" particular ingredients, components, compositions, etc., disclosed throughout the disclosure.

The present disclosure describes a piezoelectric composite, which demonstrates low dielectric loss even when such a piezoelectric composite is exposed to humid or high moisture environment. Desirably, the piezoelectric composite retains suitable piezoelectric charge coefficient (d₃₃) even when exposed to a high moisture environment.

In some aspects of the invention, the invention relates to a piezoelectric composite, comprising: (a) a polymer matrix; and (b) a plurality of coated piezoelectric filler particles, wherein each of the plurality of coated piezoelectric filler particles is dispersed in the polymer matrix, and further wherein each of the plurality of coated piezoelectric filler particles comprises a having at least one polar functional group.

The expression "plurality of coated piezoelectric filler particles" as used throughout this disclosure means 2 or more, preferably 5 or more, preferably 10 or more, preferably 50 or more, 100 or more, preferably 500 or more, preferably 1000 or more, preferably 10000 or more of coated piezoelectric filler particles being dispersed throughout the polymer matrix.

The expression "coated piezoelectric filler particles comprises a piezoelectric material having at least a portion of its outer surface coated with a polymeric material" means each of the piezoelectric filler particles is partially or completely coated by a polymeric material or an aggregate of one or more piezoelectric filler material is partially or completely coated by a polymeric material. In some preferred embodiments of the invention, the piezoelectric filler particle is completely coated by a polymeric material such that the particle is encapsulated by the polymeric material. In some preferred embodiments of the invention, the piezoelectric filler particles are coated with the polymeric material prior to dispersing the coated piezoelectric filler particles in the polymer matrix.

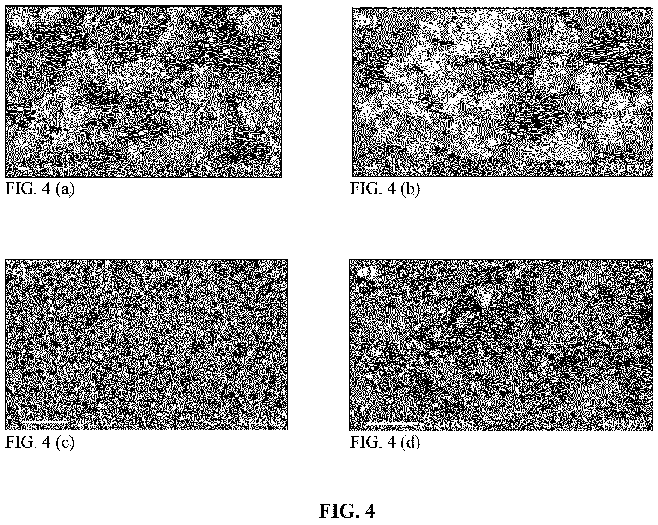

A piezoelectric composite having a coated filler particle may for example be visually distinguished from a piezoelectric composite having uncoated filler by evaluating the surface porosity of a piezoelectric composite using Scanning Electron Microscopy (SEM). For example, a piezoelectric composite having uncoated KNLN3 particles may be distinguished from a piezoelectric composite having PDMS coated KNLN3 particles, by evaluating the SEM images of FIG. 4 (c) and FIG. 4(d).

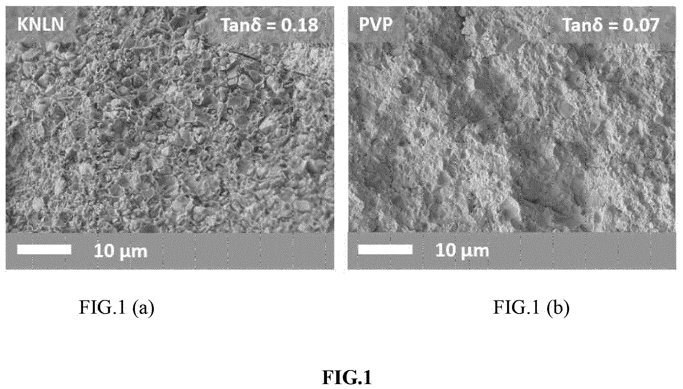

Similarly, from the SEM images under FIG. 1 (a) and FIG. 1 (b), the distinction between piezoelectric composites having uncoated and coated fillers may be ascertained by a skilled person, where the SEM image of the precursor film/piezoelectric composite of FIG. 1 (b) indicates reduced surface porosity compared to the precursor film/piezoelectric composite illustrated under FIG. 1 (a).

Further, a coated filler particle may be distinguished from an uncoated filler particle using a SEM image (e.g. FIG. 4 (a) and FIG. 4 (b)), thereby enabling a skilled person to clearly distinguish between a coated filler particle and an uncoated filler particle. Further from the results provided under Example 2 and Example 3 in this disclosure, the lower dielectric loss and improved piezoelectric performance of films containing composites having coated filler particles is clearly evidenced over that of fillers having composites with uncoated filler particles.

In some embodiments of the invention, the polymeric material comprises at least one polar functional group selected from hydroxyl group, carboxylate group, ester group, sulfonic acid group, amide group, siloxane group, amino group, sulfhydryl, phosphate, ether group, halogen group, and nitrile group. In some embodiments of the invention, the amide functional group for example may be cyclic amide with a group having -(C=O)-N- being part of a cyclic ring as present in polyvinylpyrolidone (PVP). Without wishing to be bound by any specific theory, the presence of a polar functional group aids in the adhesion of the polymeric material on the surface of the piezoelectric material. In some preferred aspects of the invention, the polymeric material comprises (i) a hydrophilic part which enables the adhesion to the piezoelectric material, and (ii) a hydrophobic part which serves as a moisture barrier coating.

In some embodiments of the invention, the plurality of coated piezoelectric filler particles are present in an amount ≥ 20.0 volume% and ≤ 80.0 volume%, alternatively ≥ 30 volume% and ≤ 60 volume%, alternatively ≥ 45 volume% and ≤ 55 volume%, with regard to the total volume of the piezoelectric composite. In some preferred embodiments of the invention, the plurality of coated piezoelectric filler particles are present in an amount of 50 volume% with regard to the total volume of the piezoelectric composite.

In some embodiments of the invention, the piezoelectric material is selected from hydroxyapatite, apatite, lithium sulfate monohydrate, sodium bismuth titanate, quartz, tartaric acid, poly(vinylidene difluoride), barium titanate, potassium sodium niobate (KNaNb)O₃ (KNN), lead zirconate titanate (PZT), lead niobium titanate (PNT), lead scandium niobium titanate (PSNT), lead metaniobate, lithium doped potassium sodium niobate (KNLN) represented by the formula (K_{0.5}Na_{0.5})₁₋ₜLiₜNbO₃, wherein the variable 't' ranges from greater than 0.01 to less than 1.0 (0.01 <t<1.00), alternatively greater than 0.02 to less than 0.09.

In some preferred embodiments of the invention, the piezoelectric material is a lead free piezoelectric material selected from hydroxyapatite, apatite, lithium sulfate monohydrate, sodium bismuth titanate, quartz, tartaric acid, poly(vinylidene difluoride), barium titanate, potassium sodium niobate (KNaNb)O₃ (KNN), lithium doped potassium sodium niobate (KNLN) represented by the formula (K_{0.5}Na_{0.5})₁₋ₜLiₜNbO₃, wherein the variable 't' ranges from greater than 0.01 to less than 1.0 (0.01<t<1.00), alternatively greater than 0.02 to less than 0.09.

In some aspects of the invention, the piezoelectric material has a suitable size and morphology for piezoelectric application and can be prepared for example, by a two-step calcination process. For example, the steps for preparing the piezoelectric material includes obtaining a precursor product after a first calcination step involving the calcination of a stoichiometric mixture of precursor metal salts such as carbonate metal salts or a mixture of oxide compounds.

The first calcination step involves calcination at a temperature > 925 °C, preferably > 1000 °C and < 1500 °C. The first calcination step maybe carried out for at least two hours, alternatively for at least three hours at a heating rate of 5 °C min⁻¹ to obtain the precursor product. In some embodiments of the invention, the precursor product is a ceramic product. The precursor product is subsequently milled using a mortar and pestle or by hand, to form a powder. The powder so obtained may be subjected to a second step of calcination carried out a temperature lower than the first calcination step, for example at a temperature < 1000 °C. The second calcination step may be carried out for at least nine hours, preferably at least ten hours at a heating rate of 1°C min⁻¹. The precursor metal salts can be sodium carbonate or potassium carbonate or lithium carbonate, while metal oxides can be for example, niobium oxide.

The coated piezoelectric filler particles can be prepared by following the general procedure: (a) providing a coating solution comprising a solubilized polymer or the corresponding monomer dissolved in a solvent; (b) dispersing one or more piezoelectric particle containing the piezoelectric material in the coating solution and forming a coating precursor solution; (c) removing the solvent from the coating precursor solution under conditions suitable for coating the one or more piezoelectric particle with the polymer and forming the coated piezoelectric filler particle. In some aspects of the invention, conditions suitable for coating include conditions of polymerizing the monomer to form a coating around the piezoelectric particle.

In some aspects of the invention, the solvent may be removed using a low pressure evaporation in a rotary evaporator. It is believed that by removing the solvent in this manner ensures intimate contact between the piezoelectric particle and polymer. The selection of solvent would depend largely upon the solubility of the polymer. For example, when polyvinylpyrolidone (PVP) is used as a coating polymer, the solvent used can be water. On the other hand, when polydimethylsiloxane (PDMS) is used as a coating polymer the solvent is cyclohexane.

In some embodiments of the invention, the polymeric material is selected from polydimethylsiloxane (PDMS), polyvinylpyrrolidone (PVP), grafted polyolefins, acrylate and methacrylate polymers, polyethylene glycol, vinyl acetate polymers polycarbonate, vinylidene fluoride (VDF) polymers, cyano polymers, poly(phenylene oxide) or combinations thereof. In some preferred embodiments of the invention, the polymeric material is selected from polydimethylsiloxane (PDMS), or polyvinylpyrrolidone (PVP).

In some embodiments of the invention, the polymeric material is selected from polyvinylpyrrolidone (PVP) or polydimethylsiloxane (PDMS) and the piezoelectric material is a lithium doped potassium sodium niobate (KNLN) represented by the formula (K_{0.5}Na_{0.5})₁₋ₜLiₜNbO₃ wherein 't' is 0.03 (KNLN3) or 't' is 0.06 (KNLN6).

In some embodiments of the invention, the polymeric material is polyvinylpyrrolidone (PVP) and the piezoelectric material is a lithium doped potassium sodium niobate (KNLN) represented by the formula (K_{0.5}Na_{0.5})₁₋ₜLiₜNbO₃ wherein 't' is 0.03 (KNLN3) or 't' is 0.06 (KNLN6).

In some embodiments of the invention, the polymeric material is polydimethylsiloxane (PDMS) and the piezoelectric material is a lithium doped potassium sodium niobate (KNLN) represented by the formula (K_{0.5}Na_{0.5})₁₋ₜLiₜNbO₃ wherein 't' is 0.03 (KNLN3) or 't' is 0.06 (KNLN6). For the purpose of clarification, the expression, KNLN3 is used to represent the piezoelectric material of formula (K_{0.5}Na_{0.5})₁₋ₜLiₜNbO₃ when the value of 't' is 0.03 and the expression, KNLN6 is used to represent the piezoelectric material of the formula (K_{0.5}Na_{0.5})₁₋ₜLiₜNbO₃ when the value of 't' is 0.06.

In some preferred aspects of the invention, the polymer matrix is a vinylidene fluoride (VDF) polymer selected from polyvinylidene fluoride (PVDF), polyvinylidene fluoride-co-tri-fluoroethylene (PVDF-TrFE), poly(vinylidene fluoride-co-hexafluoropropylene)(PVDF-HFP), polyvinylidene fluoride-co-tetrafluoro ethylene (PVDF-TFE), poly(vinylidene fluoride-co-trifluoroethylene-co-chlorofluoroethylene) (PVDF-TrFE-CFE), poly(vinylidene-fluoride-co-trifluoroethylene-co-chlorotrifluoroethylene) (PVDF-TrFE-CTFE) or combinations thereof.

In some embodiments of the invention, the polymer matrix is a polyolefin co-polymer selected from ethylene alpha-olefin copolymers, propylene alpha-olefin copolymers, ethylene-propylene alpha-olefin terpolymers, wherein the copolymers are derived from one or more alpha-olefins moieties selected from 1 -butene, 4-methyl-1-pentene, 1-hexene, 1-octene, 1-decene, 1-dodecene, 1-tetradecene, 1-hexadecene, 1-octadecene and 1-eicosene, or combinations polyolefin thereof. In some preferred embodiments of the invention, the polymer matrix is a polyolefin co- polymer comprising moieties derived from ethylene and 1-octene. In some preferred embodiments of the invention, the polymer matrix is a polyolefin co-polymer comprising moieties derived ethylene and 1 - hexene.

According to the invention, the polymer matrix and the polymeric material coating of the piezoelectric material are of different polymer composition.

Preferably the polymeric material is selected from polydimethylsiloxane (PDMS), polyvinylpyrrolidone (PVP), grafted polyolefins, polyethylene glycol, vinyl acetate polymers, cyano polymers, or combinations thereof and preferably the polymer matrix is a polymer selected from vinylidene fluoride (VDF) polymer, polycaprolactone, polyolefin co-polymers, polysiloxane-polycarbonate copolymers, acrylate and/or methacrylate copolymers, polyethylene terephthalate (PET), polycarbonate (PC), polybutylene terephthalate (PBT), poly(1,4-cyclohexylidene cyclohexane-1,4-dicarboxylate) (PCCD), glycol modified polycyclohexyl terephthalate (PCTG), poly(phenylene oxide) (PPO), polypropylene (PP), polyethylene (PE), polyvinyl chloride (PVC), polystyrene (PS), polyethyleneimine or polyetherimide (PEI) and their derivatives, terephthalic acid (TPA) polymers, poly(cyclohexanedimethylene terephthalate) (PCT), polyethylene naphthalate (PEN), polyamide (PA), polysulfone sulfonate (PSS), sulfonates of polysulfones, polyether ether ketone (PEEK), acrylonitrilebutadiene styrene (ABS), polyether ketone ketone (PEKK), polyphenylene sulfide (PPS), or blends or combinations thereof.

Preferably the polymeric material is selected from polydimethylsiloxane (PDMS), or polyvinylpyrrolidone (PVP) and the polymer matrix is a polymer selected from vinylidene fluoride (VDF) polymer.

In some embodiments of the invention, the piezoelectric composite comprises:
a. ≥ 20.0 volume% and ≤ 80.0 volume%, preferably ≥ 30.0 volume% and ≤ 55.0 volume%, preferably 50 volume%, with regard to the total volume of the piezoelectric composite, of the polymer matrix selected from poly(vinylidene fluoride-co-trifluoroethylene-co-chlorofluoroethylene) (PVDF-TrFE-CFE) or polyvinylidene fluoride- co-tri-fluoroethylene (PVDF-TrFE); and
b. ≥ 20.0 volume % and ≤ 80.0 volume %, preferably ≥ 45.0 volume % and ≤ 70.0 volume %, preferably 50 volume%, with regard to the total volume of the piezoelectric composite, of the plurality of coated piezoelectric filler particles, wherein each of the plurality of coated piezoelectric filler particles comprises a piezoelectric material comprising lithium doped potassium sodium niobate (KNLN) represented by the formula (K_{0.5}Na_{0.5})₁₋ₜLiₜNbO₃ wherein 't' is 0.03 (KNLN3) and wherein the piezoelectric material is coated with polyvinylpyrrolidone (PVP).

In some embodiments of the invention, the piezoelectric composite comprises:
a. ≥ 20.0 volume% and ≤ 80.0 volume%, preferably ≥ 30.0 volume% and ≤ 55.0 volume%, preferably 50 volume%, with regard to the total volume of the piezoelectric composite, of the polymer matrix selected from poly(vinylidene fluoride-co-trifluoroethylene-co-chlorofluoroethylene) (PVDF-TrFE-CFE) or polyvinylidene fluoride- co-tri-fluoroethylene (PVDF-TrFE); and
b. ≥ 20.0 volume % and ≤ 80.0 volume %, preferably ≥ 45.0 volume % and ≤ 70.0 volume %, preferably 50 volume%, with regard to the total volume of the piezoelectric composite, of the plurality of coated piezoelectric filler particles, wherein each of the plurality of coated piezoelectric filler particles comprises a piezoelectric material comprising lithium doped potassium sodium niobate (KNLN) represented by the formula (K_{0.5}Na_{0.5})₁₋ₜLiₜNbO₃ wherein 't' is 0.03 (KNLN3) and wherein the piezoelectric material is coated with polydimethylsiloxane (PDMS).

In a preferred aspect of the invention, the invention is directed to a film comprising the piezoelectric composite of the present invention. The expression "film" as used throughout this disclosure means a film which is piezo active.

In some embodiments of the invention, the invention is directed to a film comprising the piezoelectric composite, wherein the piezoelectric composite comprises:
a. ≥ 20.0 volume% and ≤ 80.0 volume% with regard to the total volume of the piezoelectric composite, of a polymer matrix selected from poly(vinylidene fluoride-co-trifluoroethylene-co-chlorofluoroethylene) (PVDF-TrFE-CFE) or polyvinylidene fluoride- co-tri-fluoroethylene (PVDF-TrFE); and
b. ≥ 20.0 volume% and ≤ 80.0 volume% with regard to the total volume of the piezoelectric composite, of a plurality of coated piezoelectric filler particles dispersed in the polymer matrix, wherein each of the plurality of coated piezoelectric filler particles comprises a piezoelectric material comprising lithium doped potassium sodium niobate (KNLN3) represented by the formula (K_{0.5}Na_{0.5})₁₋ₜLiₜNbO₃, wherein 't' is 0.03 or 't' is 0.06 and wherein the piezoelectric material is coated with a polymeric material selected from polyvinylpyrolidone (PVP) or polydimethylsiloxane (PDMS).

Further, without wishing to be bound by any specific theory, it is believed that by processing the composite in the form of a film, the film can be tuned to have suitable mechanical flexibility and thereafter incorporated in various articles of manufacture.

In some aspects of the invention, the invention is directed to a method for preparing a film comprising the piezoelectric composite of the present invention, wherein the method comprises:
a. dissolving a polymer in an organic solvent and forming a polymer solution;
b. adding a plurality of coated piezoelectric filler particles to the polymer solution and forming a precursor piezoelectric composite solution;
c. casting the precursor piezoelectric composite solution on a substrate and forming a precursor film; and
d. subjecting the precursor film to an electric polarization treatment and forming the film.

In some embodiments of the invention, the polymer solution may be in the form of a polymer matrix. Preferably, the piezoelectric filler particles are coated prior to introducing the coated filler particles into the polymer solution. Without wishing to be bound by any specific theory, the coating of the filler particles prior to dispersing in the polymer solution, improves the dispersion of the filler particles and imparts improved piezoelectric property to a film comprising piezoelectric composite of the present invention.

Accordingly, in some embodiments of the invention, the invention is directed to a film obtained by a method comprising the steps of:
a. dissolving a polymer in an organic solvent and forming a polymer solution;
b. adding a plurality of coated piezoelectric filler particles to the polymer solution and forming a precursor piezoelectric composite solution;
c. casting the precursor piezoelectric composite solution on a substrate and forming a precursor film; and
d. subjecting the precursor film to an electric polarization treatment and forming the film.

Some of the differences in properties between the precursor film and film, is that the film is piezo-active while the precursor film is not piezo-active.

In some embodiments of the invention, the substrate used for casting is a glass plate. Non-limiting examples of organic solvent used for preparing the film include tetrahydrofuran (THF), methyl ethyl ketone (MEK), dimethylsulfoxide (DMSO), dimethylformamide (DMF), N-methyl-2-pyrrolidone (NMP), 1,2 dichloro benzene, 1,2,4 trichlorobenzene, cyclehexane, toluene, p-xylene or combinations thereof. In some preferred embodiments of the invention, the organic solvent is a 50/50 volume mixture of tetrahydrofuran (THF) and dimethylformamide (DMF). In some preferred embodiments of the invention, the organic solvent is dimethylformamide (DMF).

In various embodiments of the invention, casting of the precursor piezoelectric composite solution can include spreading the precursor piezoelectric composite solution on a substrate. The expression "casting" as used for the purposes of this invention includes the process of removing the solvent. Non-limiting examples of casting include air casting (e.g., the precursor piezoelectric composite solution can be passed under a series of air flow ducts that controls the evaporation of the organic solvents in a particular set period of time such as 24 to 48 hours), solvent or emersion casting, (e.g., the precursor piezoelectric composite solution is spread onto a moving belt and run through a bath or liquid in which the liquid within the bath exchanges with the organic solvent). The spreading of the precursor piezoelectric composite solution on the substrate can be carried out using a doctor blade, rolling spreader bar or any such suitable apparatus.

In some aspects of the invention, the precursor piezoelectric composite solution is dried at any temperature ≥ 25 °C and ≤ 80 °C, alternatively ≥ 45 °C and ≤ 70 °C, to remove the organic solvent and forming the precursor film. In some embodiments of the invention, the precursor film is annealed prior to poling. The annealing of the precursor film may be carried out at any temperature ≥ 80 °C and ≤ 150 °C for any time period ≥1 hour and ≤ 50 hours, preferably annealing the precursor film at a temperature of 110 °C for any time period ≥ 5 hours and ≤ 25 hours.

The expression "poling" as used throughout this disclosure means a process of inducing electric polarization in a material to specifically orient the piezoelectric filler particles along the direction of the applied field or any such predetermined orientation. During electric polarization, the coated piezoelectric filler particles can be connected to one another in a linear or a semi-linear manner (e.g., chains of particles). Columns of piezoelectric particles are suitably formed by aligning of more than one chain. By way of example, the film precursor, can be poled at a selected electric field at a specific temperature. The selected temperature may for example, be chosen in accordance with a desired dipole orientation, or a desired polarization strength, or as required for an intended application area. The applied voltage parameter for poling can be selected in various ways. For example, the applied voltage level parameter can be selected as constant, or changing (e.g., ramped) over a period of time. In some embodiments of the invention, poling is performed using corona discharge in a corona polarization instrument having an electrode gap of 0.5 cm to 1.5 cm.

In some embodiments of the invention, the electric polarization treatment is conducted at an electric field ≥ 5 KV/mm and ≤ 100 KV/mm, alternatively ≥ 10 KV/mm and ≤ 80 KV/mm, or alternatively ≥ 20 KV/mm and 60 KV/mm, for a time period ≥ 1 minute and ≤ 120 minutes, alternatively ≥ 20 minutes and ≤ 100 minutes, or alternatively ≥ 50 minutes and ≤ 80 minutes, and at any temperature ranging ≥ 50 °C and ≤ 120 °C, or alternatively from ≥ 70 °C and ≤100 °C.

In some aspects of the invention, the dielectric loss (tanδ) for a film comprising the piezoelectric composite is sufficiently low even when the film is exposed to humid or a high moisture environment. In other words, when the film comprising the piezoelectric composite of the present invention, is used in devices such as actuators or sensors, internal heating of the devices due to dielectric loss is minimized resulting in a more efficient operation of the device.

The dielectric loss may for example be measured by applying alternate current voltage and measuring the phase difference between the voltage waveform and the resulting current waveform, which provides the (tanδ) value or the dielectric loss. Dielectric loss may for example be measured using any suitable techniques such as by using impedance analyzer such as Agilent 4294A or the Novocontrol High Frequency Impedance Analyzer, Model Alpha AT.

In some aspect of the invention, the inventors surprisingly found that a film comprising the piezoelectric composite of the present invention, retained sufficiently high piezoelectric charge coefficient (d₃₃) along with low dielectric loss even when the film is exposed to humidity.

In some embodiments of the invention, the piezoelectric charge coefficient (d₃₃) ≥ 2 pC/N and ≤ 100 pC/N, alternatively from ≥ 15 pC/N and ≤ 80 pC/N, or alternatively ≥ 40 pC/N and ≤ 60 pC/N, wherein the piezoelectric charge coefficient (d₃₃) is measured at a frequency of 1000 Hz. The piezoelectric charge coefficient (d₃₃) may be measured by using any known instruments typically used in the industry such as by the PiezoMeter System, model PM300. The dielectric loss, piezoelectric charge coefficient may for example be measured in accordance with the ASTM D 150-18.

In some embodiments of the invention, the film comprising the piezoelectric composite of the present, invention has a thickness ≥ 20 micrometers and ≤ 500 micrometers, alternatively a thickness ≥ 60 micrometers and ≤ 400 micrometers, or alternatively a thickness of ≥ 100 micrometers and ≤ 300 micrometers.

In various aspects of the invention, the invention is directed to an article of manufacture comprising the film comprising the piezoelectric composite of the present invention. In some embodiments of the invention, the article of manufacture is a component of a touch panel, a human machine interface, an integrated keyboard, or a wearable device.

Specific examples demonstrating some of the embodiments of the invention are included below. The examples are for illustrative purposes only and are not intended to limit the invention. It should be understood that the embodiments and the aspects disclosed herein are not mutually exclusive and such aspects and embodiments can be combined in any way. Those of ordinary skill in the art will readily recognize parameters that can be changed or modified to yield essentially the same results.

### EXAMPLES

### Example 1

### Synthesis of piezoelectric filler particles (KNLN3) having the formula (K_{0.5}Na_{0.5})₁₋ₜLiₜNbO₃ at 't' is 0.03(K_{0.485}Na_{0.485}Li_{0.03}NbO₃)

**Purpose:** Example 1 illustrates a method of preparation of piezoelectric fillers (KNLN3) having the formula K_{0.485}Na_{0.485}Li_{0.03}NbO₃.

**Materials:** The table below provides a summary of the materials used for preparing the fillers and the suppliers from whom the raw materials were procured:

**Table 1: Material description**

| Precursor Metal salts | Purity metal compound precursor | Mol.% | Required weight for 50 g KNLN3 (g) | Supplier |
|---|---|---|---|---|
| Na₂CO₃ | 99.5% | 0.035 | 7.51 | Sigma Aldrich |
| K₂CO₃ | 99.0% | 0.035 | 9.78 | Sigma Aldrich |
| Nb₂O5 | 99.9% | 0.073 | 38.82 | Sigma Aldrich |
| Li₂CO₃ | 99.0% | 0.0022 | 0.32 | Sigma Aldrich |

**Process for preparation:** The following general method was practiced for preparing the (KNLN3) piezoelectric ceramic filler: stoichiometric proportions of metal compound precursors of K₂CO₃, Na₂CO₃, Li₂CO₃, and Nb₂O₅ powders were mixed in a cyclohexane medium using polypropylene lined mixer and using zirconia balls for 3 hours for homogenization. The resulting suspension so obtained was filtered and dried in a hot air oven for 24 hours to form the metal salt mixture composition. The metal salt mixture composition was subjected to a first and second calcination step to obtain the piezoelectric filler.

First calcination step: The calcination of the dried metal salt mixture composition was performed in a closed alumina crucible at a first calcination temperature by heating the samples at a rate of 5° C/min until the first calcination temperature was reached at 1050 °C. Thereafter, the temperature was maintained at the first calcination temperature for 3 hours and subsequently cooled to ambient temperature. After the first calcination, the powder was ball milled for 3 hours to refine the particle size.

Second calcination step: After ball milling, samples were heated to a second calcination temperature at a rate of 1 °C/min until the second calcination temperature was reached at 925 °C and thereafter maintained for 10 hours, and then cooled to ambient temperature. After calcination, the powders were ultrasonicated for 1 hour in a cyclohexane medium, dried at 150 °C for 3 hours and stored in an air ventilated drying oven to avoid moisture absorption.

### Example 2 (Inventive)

### Preparing a film containing a piezoelectric composite having 50 volume% of polyvinylpyrrollidone (PVP) coated KNLN (KNLN3) piezoelectric filler particles

**Purpose:** Example 2 illustrates the performance of a film comprising piezoelectric composite having 50 volume% of polyvinyl-pyrrollidone (PVP) coated KNLN3 as piezoelectric filler particles which are dispersed in a PVDF-TrFE-CFE polymer matrix. The KNLN3 particles are represented by the formula (K_{0.5}Na_{0.5})₁₋ₜLiₜNbO₃ at 't' is 0.03 (K_{0.485}Na_{0.485}Li_{0.03}NbO₃) and are prepared in accordance with the method described under Example 1.

**Material used:** The following are the details of the material used:

**Table 2: Piezoelectric composite having PVP coated KNLN3 fillers**

| Components | Material | Supplier |
|---|---|---|
| Polymer matrix | Poly(vinylidene fluoride-co-trifluoroethylene-co-chlorofluoroethylene) (PVDF-TrFE-CFE) | Piezotech Arkema |
| Piezoelectric particle | KNLN3 | Prepared as described in Example 1 |
| Coating used (polymeric material) | Polyvinylpyrrolidone (PVP) | Sigma Aldrich |
| Coated piezoelectric filler particle | PVP coated KNLN3 particle | As prepared by the method described below |

**Method for preparing the coated PVP piezoelectric filler particles:** About 5 g of KNLN3 was suspended in 2 L of a 0.06 mM aqueous solution containing polyvinylpyrrolidone (PVP) and thereafter stirred for 12 hours. The particles were then isolated by centrifuging for 10 minutes at 4400 rpm and the supernatant was decanted. The piezoelectric filler particles so obtained were subsequently dried overnight at 110 °C to obtain the PVP coated filler particles.

**Method for preparing a film containing the piezoelectric composite having PVP coated piezoelectric particles:** The general method used for preparing the film containing the piezoelectric composite was as follows: (a) dissolving a polymer in an organic solvent and forming a polymer solution; (b) adding a plurality of PVP coated piezoelectric filler particles to the polymer solution and forming a precursor piezoelectric composite solution; (c) thereafter, casting the precursor piezoelectric composite solution on a substrate and forming a precursor film; and (d) subjecting the precursor film to an electric polarization treatment and forming the film. For the purpose of the present example, the precursor film was annealed prior to the electric polarization treatment.

In particular to produce the piezoelectric composite, a 15 wt.% solution of poly(vinylidene fluoride-co-trifluoroethylene-co-chlorofluoroethylene) (PVDF-TrFE-CFE) (obtained from Piezotech Arkema) in dimethylformamide (DMF), was prepared (polymer solution). The PVP coated KNLN3 particles were mixed into this polymer solution using a Hauschild DAC 150 FVZ planetary speed mixer at 750 rpm for 5 minutes to obtain the precursor piezoelectric composite solution. Thereafter, precursor piezoelectric composite solution was subjected to degassing, for several minutes in a vacuum pot, and thereafter the precursor piezoelectric composite solution was casted on a glass plate using a doctor blade technique at a cast height of 1mm to form a precursor film.

The precursor film was dried in a vacuum oven at 70 °C for 1 hour before annealing at 110 °C for 2 hours. In order to make the precursor film piezoactive, poling was carried out in a heated silicone oil bath at 110°C for 10 minutes at a field of 10 kV/mm. Once poling was complete the field was switched off and the precursor film was removed from the bath and thereafter thermally quenched to obtain a film containing the PVP coated KNLN3 filler particles. Once annealing was finished a number of discs (12 mm diameter) were cut from the composite for electrical testing. Gold electrodes were sputtered onto the composite discs using a Quorum Q300T sputter coater.

The electrical properties of the discs were measured using an Agilent 4263B LCR meter. Broadband dielectric spectroscopy was performed using a Single-Unit Dielectric Alpha Analyzer from Novocontrol. The piezoelectric properties were measured using a PM300 Berlin court-type piezometer from Piezotest with a static force of 10 N and a dynamic force of 0.25 N peak to peak with sinusoidal excitation at 110 Hz. Electrical measurements were performed using a Novocontrol Alpha Dielectric Analyzer in the frequency range from 1 Hz to 10 MHz at room temperature with a fixed potential difference of 1 V.

**Evaluation of piezoelectric property of a film having PVP coated piezoelectric fillers:** For evaluating the efficacy of the coating on the piezoelectric filler particles against moisture, the dielectric loss (tanδ) was evaluated using broadband dielectric spectroscopy. Alternate current having a frequency within the frequency range of 1-10⁶ Hz was thereafter used for the evaluation.

The piezoelectric film samples were analyzed for their piezoelectric property under different relative humidity conditions. Three different film samples were derived from the film obtained from the practice of Example 2. Subsequently, each of the film samples were aged for two days under a specific relative humidity (Rh) condition (25%, 55%, 95%). For exposure at 95% relative humidity (Rₕ), the film sample was stored in a chamber under humid conditions for two days. For exposure at 55% humidity, the film sample was stored for two days and thereafter exposed to ambient air atmosphere. For exposure at 25% humidity, a film sample was stored in a vacuum pot in presence of a desiccating silica gel for two days.

As an experiment control, the dielectric loss (tanδ) was determined for a film prepared using uncoated KNLN3 filler particles dispersed in a PVDF-TrFE-CFE polymer matrix. The effect of humidity on dielectric loss was determined and the results of the test are provided below in Table 3:

**Table 3: Piezoelectric property measured for dielectric loss at different relative humidity**

| | Rₕ=25% | | Rₕ=55% | | Rₕ=95% | |
|---|---|---|---|---|---|---|
| Frequency (Hz) | Coated Tan(δ) | Uncoated Tan(δ) | Coated Tan(δ) | Uncoated Tan(δ) | Coated Tan(δ) | Uncoated Tan(δ) |
| 1.0 | 0.20221 | 0.5692 | 0.44331 | 0.6257 | 0.47368 | 0.9873 |
| 10.2035 | 0.09647 | 0.2744 | 0.17762 | 0.58861 | 0.5262 | 0.5003 |
| 107.559 | 0.06168 | 0.12997 | 0.08235 | 0.3955 | 0.46177 | 0.49418 |
| 1133.82 | 0.06185 | 0.08143 | 0.06505 | 0.1777 | 0.23284 | 0.7284 |
| 11952 | 0.10981 | 0.11401 | 0.10795 | 0.13384 | 0.16507 | 0.87838 |
| 89992.8 | 0.23349 | 0.23335 | 0.22707 | 0.24381 | 0.25355 | 0.72389 |
| 1000000 | -1.18055 | 0.04546 | -1.0852 | 0.3128 | -1 .06046 | 0.06586 |

In addition to the above tests, the piezoelectric charge coefficient (d₃₃), dielectric loss (tanδ) and relative permittivity was measured at 1 kHz at relative humidity (Rₕ) ~55% and the results are provided in the table below:

**Table 4: Piezoelectric charge coefficient, dielectric loss and relative permittivity at 1 kHz frequency**

| | Film having uncoated KNLN3 fillers (standard deviation) | Film having PVP coated KNLN3 fillers (standard deviation) |
|---|---|---|
| Tan(δ) (-) | 0.18 | 0.06 |
| εᵣ (-) | 131.0 | 147 |
| d₃₃ (pC/N) | 33 (4) | 36 (4) |
| Density (%) | 81 (3) | 89 (1) |

**Results:** From Table 3, it is evident that the piezoelectric filler particles on being coated with PVP results in lower dielectric loss even at high relative humidity (Rₕ) environment of 95%. For example, at a frequency of 1133.82 Hz, the dielectric loss (tan(δ)) of a film exposed to 95% relative humidity (Rₕ=95%) and having PVP coated fillers had nearly 70 % lower dielectric loss (tan(δ)) compared to a film having uncoated filler particles. Similarly at a frequency of 11952 Hz, the dielectric loss (tan(δ)) of a film having PVP coated fillers was more than 80% lower compared to a film having uncoated filler particles.

From Table 4, it is evident that the film having PVP coated piezoelectric fillers, has lower dielectric loss (Tan(δ) of about 66% lower) compared to a film having uncoated filler particles while improving piezoelectric charge coefficient (d₃₃). It is suspected that the reason why dielectric loss is reduced significantly with PVP coating is due to the improvement in the dispersion of the filler particles in the polymer matrix, which is also evident from the SEM images. Further, although relative permittivity increases marginally for the film sample containing coated filler particles, it is expected that such marginal increase in relative permittivity will not adversely affect piezoelectric constant 'g', indicating that sensing performance of the film using piezoelectricity, is retained.

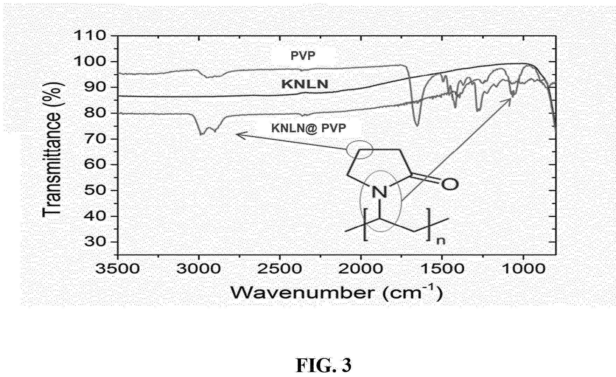

From FIG.3, the incorporation of the PVP coat on the KNLN particle may be further concluded from the Fourier Transformed Infrared spectrograph (FT-IR). The spectrograph indicates characteristic signals for the 1) uncoated KNLN3 powder, 2) the isolated PVP coating, and 3) of the KNLN3 powder after functionalization with PVP. The appearance of characteristic spectra shifts at 3000 cm⁻¹ and 1100 cm⁻¹ for C-H and C-N stretching respectively, confirming the presence of PVP on the surface of the KNLN3 particles.

In fact for PVP, it is believed that the presence of polar C-N and C=O bonds enable improved adhesion with the highly polar and hydrophilic ceramic surface of the KNLN3 particles, while the non-polar alkyl chain results in improved compatibilization with the polymer matrix.

FIG. 1 (b) illustrates a SEM image where a composite prepared using PVP coated filler particles demonstrates improved microstructure morphology indicating improved compatibilization between the PVP coated filler particles and the polymer matrix, as compared to a composite having uncoated filler particles as shown in FIG.1 (a). FIG. 1 (a) may represent a typical piezoelectric composite material in which the piezoelectric filler particles are dispersed in a matrix without the fillers having a surface coating and is therefore outside the scope of the invention.

### Example 3 (Inventive)

### Preparing a film containing a piezoelectric composite having 50 volume% of polydimethylsiloxane (PDMS) coated KNLN (KNLN3) piezoelectric filler particles

**Purpose:** Example 3 illustrates the performance of a piezoelectric composite having 50 volume% of polydimethylsiloxane (PDMS) coated KNLN3 as the piezoelectric filler particles dispersed in a polyvinylidene flttoride-co-tri-fluoroethylene polymer matrix. The KNLN3 filler particles are represented by the formula (K_{0.5}Na_{0.5})₁₋ₜLiₜNbO₃ where 't' is 0.03 (K_{0.485}Na_{0.485}Li_{0.03}NbO₃) and are prepared in accordance with the method described under Example 1.

**Material used:** The following are the details of the material used:

**Table 5: Piezoelectric composite having PDMS coated fillers**

| Components | Material | Supplier |
|---|---|---|
| Polymer matrix | Polyvinylidene fluoride-co-tri-fluoroethylene (PVDF-TrFE) | Piezotech Arkema |
| Piezoelectric particle | KNLN3 | Prepared as described in Example 1 |
| Coating used (polymeric material) | Polydimethylsiloxane (PDMS) | Sigma Aldrich |
| Coated piezoelectric filler particle | PDMS coated KNLN3 particle | |

**Method for preparing the PDMS coated piezoelectric filler particles:** The piezoelectric particles were obtained in the manner as described in Example 1. Thereafter, the particles were coated with polydimethylsiloxane polymer using the following steps: 0.3 g of dimethyl siloxane (PDMS monomer), was dissolved in 20 mL of cyclohexane to form a solution. About 4.4 g of KNLN3 particles were added to this solution and stirred with a magnetic stirrer for 2 hours before the solvent was removed by low pressure evaporation in a rotary evaporator to obtain polydimethylsiloxane (PDMS) coated piezoelectric filler particles.

**Method for preparing a film containing PDMS coated piezoelectric particles:** The method of preparing the film was identical to that described in Example 2, except that PDMS coated filler particles were used.

**Evaluation of piezoelectric property using PDMS coated piezoelectric fillers:** The film was evaluated for piezoelectric performance. The piezoelectric charge coefficient (d₃₃), dielectric loss (tanδ) and relative permittivity were measured at 1 kHz (1000 Hz) and the results are provided in the table below:

**Table 6: Piezoelectric charge coefficient, dielectric loss and relative permittivity**

| | Film having uncoated KNLN3 fillers (standard deviation) | Film having PDMS coated KNLN3 fillers (standard deviation) |
|---|---|---|
| Tan(δ) (-) | 0.48 (10) | 0.14 (2) |
| εᵣ (-) | 123 (30) | 29 (6) |
| d₃₃ (pC/N) | 16.0 (2) | 15.4(5) |

**Result:** From Table 6, it is evident that the film prepared using PDMS coated KNLN3 filler particles had nearly 70% lower dielectric loss while retaining similar levels of piezoelectric charge coefficient (d₃₃). It may be concluded that the film of Example 3 demonstrates desirable level of piezoelectric performance. Advantageously, relative permittivity (εᵣ or dielectric constant) reduces significantly when using PDMS coated filler particles, indicating a possible increase in the value of piezoelectric voltage constant (g) and rendering such film to be suitable for use in a sensing device.

FIG. 4 (a) illustrates SEM images of an uncoated KNLN3 particles. FIG. 4 (b) illustrates a PDMS coated KNLN3 particles. FIG. 4 (c) illustrates precursor film cross section comprising uncoated KNLN3 particles and FIG.4 (d) illustrates precursor film cross section comprising PDMS coated KNLN3 particles.

FIG. 4 (c) may represent a typical piezoelectric composite material in which the piezoelectric filler particles are dispersed in a matrix without the fillers having a surface coating and is therefore outside the scope of the invention.

Comparing the images in FIG. 4 (a) and FIG. 4 (b) the successful coating of PDMS is evident from the surface morphology, which is clearly visible in image FIG. 4 (b). Further, from FIG. 4(d), it is evident that the surface porosity is considerably reduced indicating improved adhesion of the filler particles to the polymer matrix.

### Example 4 (Comparative)

### Preparing a film containing a piezoelectric composite having 50 volume% of 3-amino(propyl)-methyl-diethoxysilane (ADS) functionalized KNLN (KNLN3) piezoelectric filler particles

**Purpose:** Example 4 illustrates the performance of a piezoelectric composite having 50 volume% of 3-amino(propyl)-methyl-diethoxysilane (ADS) functionalized KNLN3 as piezoelectric filler particles. The KNLN3 particles are represented by the formula (K_{0.5}Na_{0.5})₁₋ₜLiₜNbO₃ at 't' is 0.03(K_{0.485N}a_{0.485}Li_{0.03}NbO₃) and are prepared in accordance with the method described under Example 1. The polymer matrix used was poly(vinylidene fluoride-co-trifluoroethylene-co-chlorofluoroethylene) (PVDF-TrFE-CFE).

The functionalization of the piezoelectric filler particles with ADS was carried out similar to the manner in which PVP was coated on the filler particles except ADS merely surface functionalized the filler particles and did not form an encapsulating polymer coating.

**Evaluation of piezoelectric property using ADS functionalized piezoelectric fillers:** The effect of surface functionalization on the property of dielectric loss was evaluated in the manner described in Example 2. The results are shown in Table 7 below:

**Table 7: Piezoelectric property measured for dielectric loss**

| | Rh=25% | | Rh=95% | |
|---|---|---|---|---|
| Frequency (Hz) | Coated Tan(δ) | Uncoated Tan(δ) | Coated Tan(δ) | Uncoated Tan(δ) |
| 1.0 | 0.36436 | 0.5692 | 0.75342 | 0.9873 |
| 10.2035 | 0.15476 | 0.2744 | 0.75624 | 0.5003 |
| 107.559 | 0.08189 | 0.12997 | 0.62726 | 0.49418 |
| 1133.82 | 0.06755 | 0.08143 | 0.29698 | 0.7284 |
| 11952 | 0.1117 | 0.11401 | 0.16882 | 0.87838 |
| 89992.8 | 0.23863 | 0.23335 | 0.24203 | 0.72389 |
| 1000000 | -0.04138 | 0.04546 | 0.06243 | 0.06586 |

**Result:** From Table 7, it is evident that films prepared using ADS surface functionalized filler particles demonstrated lower dielectric loss than that of films prepared using the uncoated filler particles.

On the other hand, comparing the results provided under Table 7 with that of Table 3, it is evident that films prepared using PVP coated KNLN3 filler particles demonstrated lower dielectric loss compared to films prepared using ADS functionalized filler particles. For example, at a frequency of 1.0 Hz and exposed at 95% relative humidity (Rₕ), the film having PVP coated filler particles had a 37% lower dielectric loss compared to a film using ADS functionalized filler particles (Table 7). Similarly, at 107.559 Hz and exposed at 95% relative humidity (Rₕ), the film having PVP coated filler particles had a 25% lower dielectric loss compared to a film using ADS functionalized filler particles.

From these data it is clear that films having ADS functionalized filler particles perform better than films having uncoated KNLN3 filler particles in most conditions. However, they do not perform as well as the films comprising PVP coated filler piezoelectric particles. It is suspected that the reason that ADS functionalized filler particles do not impart similar levels of performance that of a film having PVP coated filler particles (Example 2) does, is because ADS does not form an encapsulating polymer coating around the filler particles. On the other hand, PVP coating is formed by a relatively simple polymerization process using methods such as solution casting. Therefore, it is believed that PVP forms a more complete shell around the KNLN3 filler particles.

### Example 5 (Comparative)

### Preparing a film containing a piezoelectric composite having 50 volume% of MPMDS functionalized KNLN (KNLN3) piezoelectric filler particles

**Purpose:** Example 5 illustrates the performance of a piezoelectric composite having 50 volume% of (3-mercaptopropyl)methyldimethoxysilane (MPMDS) functionalized KNLN3 as piezoelectric filler particles. The KNLN3 particles are represented by the formula (K_{0.5}Na_{0.5})₁₋ₜLiₜNbO₃ at 't' is 0.03(K_{0.485}Na_{0.485}Li_{0.03}NbO₃) and are prepared in accordance with the method described under Example 1.

The functionalization of the piezoelectric filler particles with MPMDS was carried out similar to the manner in which PVP was coated on the filler particles except MPMDS merely surface functionalized the filler particles and did not form an encapsulating polymer coating around the filler particle. The polymer matrix used was poly(vinylidene fluoride-co-trifluoroethylene-co-chlorofluoroethylene) (PVDF-TrFE-CFE).

**Evaluation of piezoelectric property using MPMDS functionalized piezoelectric fillers:** The effect on surface functionalization on the property of dielectric loss was evaluated in the manner described in Example 2. The results are shown in Table 8 below:

**Table 8: Piezoelectric property measured for dielectric loss**

| | Rh=25% | | Rh=55% | | Rh=95% | |
|---|---|---|---|---|---|---|
| Frequency (Hz) | Coated Tan(δ) | Uncoated Tan(δ) | Coated Tan(δ) | Uncoated Tan(δ) | Coated Tan(δ) | Uncoated Tan(δ) |
| 1.0 | 0.41661 | 0.5692 | 0.64425 | 0.6257 | 2.80878 | 0.9873 |
| 10.2035 | 0.17907 | 0.2744 | 0.77009 | 0.58861 | 1.35484 | 0.5003 |
| 107.559 | 0.09182 | 0.12997 | 0.53928 | 0.3955 | 0.97407 | 0.49418 |
| 1133.82 | 0.07021 | 0.08143 | 0.21362 | 0.1777 | 0.85198 | 0.7284 |
| 11952 | 0.10962 | 0.11401 | 0.13778 | 0.13384 | 0.47838 | 0.87838 |
| 89992.8 | 0.22658 | 0.23335 | 0.2282 | 0.24381 | 0.36501 | 0.72389 |
| 1000000 | -0.05791 | 0.04546 | -1.52689 | 0.3128 | -1.18535 | 0.06586 |

**Result:** From Table 8, it is evident that films containing MPMDS functionalized filler particles perform marginally better than films having uncoated KNLN filler particles in dry atmosphere (25% relative humidity). In all other conditions of humidity, it is evident that surface functionalization of the filler particles with MPMDS, results in the deterioration of the dielectric losses of the film. When compared to the performance with a film having PVP coated filler particles, the film having PVP coated filler particles had a significantly lower dielectric loss. For example, at a frequency of 11952 Hz and exposed at 95% relative humidity, the film having PVP coated filler particles had a 66% lower dielectric loss as compared to a film having MPMDS functionalized filler particles.

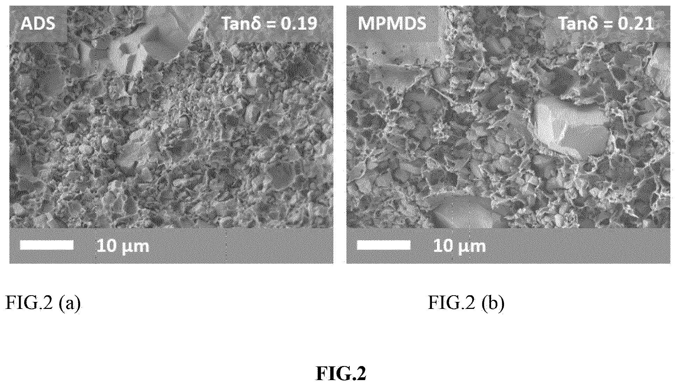

Further, from the SEM image shown in FIG. 2(b), when the KNLN filler particles are coated with MPMDS it is inferred that the adhesion of the polymer to the filler particles are drastically reduced with a visibly poorer microstructure after cracking and a corresponding increase in the dielectric loss.

**Summary:** From the results obtained from Examplel-5, it is evident that a film having filler particles coated with a polymeric material, demonstrates lower dielectric loss even when such a film is exposed to a high moisture environment compared to a film having uncoated filler particles or when the filler particles are merely surface functionalized. Surprisingly, it was found that for the films prepared in accordance with the inventive examples Example 2 and Example 3, the piezoelectric charge coefficient (d₃₃) was retained or marginally improved while demonstrating lower dielectric loss.

## Claims

1. A piezoelectric composite, comprising:
a. a polymer matrix; and
b. a plurality of coated piezoelectric filler particles, wherein each of the plurality of coated piezoelectric filler particles is dispersed in the polymer matrix, and further wherein each of the plurality of coated piezoelectric filler particles comprises a piezoelectric material having at least a portion of its outer surface coated with a polymeric material having at least one polar functional group,
**characterized in that** the polymer matrix and the polymeric material coating of the piezoelectric material are of different polymer composition.

2. The piezoelectric composite of claim 1, wherein the polymeric material comprises at least one polar functional group selected from hydroxyl group, carboxylate group, ester group, sulfonic acid group, amide group, siloxane group, amino group, sulfhydryl, phosphate, ether group, halogen group, and a nitrile group.

3. The piezoelectric composite according to any one of claims 1-2, wherein the plurality of coated piezoelectric filler particles are present in an amount ≥ 20.0 volume% and ≤ 80.0 volume%, with regard to the total volume of the piezoelectric composite.

4. The piezoelectric composite according to any one of claims 1-3, wherein the piezoelectric material is selected from hydroxyapatite, apatite, lithium sulfate monohydrate, sodium bismuth titanate, quartz, tartaric acid, poly(vinylidene difluoride), barium titanate, potassium sodium niobate (KNaNb)O₃ (KNN), lead zirconate titanate (PZT), lead niobium titanate (PNT), lead scandium niobium titanate (PSNT), lead metaniobate, lithium doped potassium sodium niobate (KNLN) represented by the formula (K_{0.5}Na_{0.5})₁₋ₜLiₜNbO₃ wherein the variable 't' ranges from greater than 0.01 to less than 1.0 (0.01<t<1.00).

5. The piezoelectric composite according to any one of claims 1-4, wherein the polymeric material is selected from polydimethylsiloxane (PDMS), polyvinylpyrrolidone (PVP), grafted polyolefins, acrylate and methacrylate polymers, polyethylene glycol, vinyl acetate polymers polycarbonate, vinylidene fluoride (VDF) polymers, cyano polymers, poly(phenylene oxide) or combinations thereof, preferably the polymeric material is selected from polydimethylsiloxane (PDMS), polyvinylpyrrolidone (PVP), grafted polyolefins, polyethylene glycol, vinyl acetate polymers, cyano polymers, or combinations thereof; more preferably the polymeric material is selected from polydimethylsiloxane (PDMS), or polyvinylpyrrolidone (PVP).

6. The piezoelectric composite according to any one of claims 1-5, wherein the polymeric material is selected from polyvinylpyrrolidone (PVP) or polydimethylsiloxane (PDMS) and the piezoelectric material is a lithium doped potassium sodium niobate (KNLN) represented by the formula (K_{0.5}Na_{0.5})₁₋ₜLiₜNbO₃ wherein 't' is 0.03 (KNLN3) or 't' is 0.06 (KNLN6).

7. The piezoelectric composite according to any one of claims 1-6, wherein the polymer matrix is a polymer selected from vinylidene fluoride (VDF) polymer, polycaprolactone, polysiloxane, polydimethylsiloxane (PDMS), polyolefin co-polymers, polysiloxane-polycarbonate copolymers, acrylate and/or methacrylate copolymers, polyethylene terephthalate (PET), polycarbonate (PC), polybutylene terephthalate (PBT), poly(I,4-cyclohexylidene cyclohexane-1,4-dicarboxylate) (PCCD), glycol modified polycyclohexyl terephthalate (PCTG), poly(phenylene oxide) (PPO), polypropylene (PP), polyethylene (PE), polyvinyl chloride (PVC), polystyrene (PS), polyethyleneimine or polyetherimide (PEI) and their derivatives, thermoplastic elastomer (TPE), terephthalic acid (TPA) polymers, poly(cyclohexanedimethylene terephthalate) (PCT), polyethylene naphthalate (PEN), polyamide (PA), polysulfone sulfonate (PSS), sulfonates of polysulfones, polyether ether ketone (PEEK), acrylonitrilebutadiene styrene (ABS), polyether ketone ketone (PEKK), polyphenylene sulfide (PPS), or blends or combinations thereof, preferably the polymer matrix is a polymer selected from vinylidene fluoride (VDF) polymer, polycaprolactone, polyolefin co-polymers, polysiloxane-polycarbonate copolymers, acrylate and/or methacrylate copolymers, polyethylene terephthalate (PET), polycarbonate (PC), polybutylene terephthalate (PBT), poly(1,4-cyclohexylidene cyclohexane-1,4-dicarboxylate) (PCCD), glycol modified polycyclohexyl terephthalate (PCTG), poly(phenylene oxide) (PPO), polypropylene (PP), polyethylene (PE), polyvinyl chloride (PVC), polystyrene (PS), polyethyleneimine or polyetherimide (PEI) and their derivatives, terephthalic acid (TPA) polymers, poly(cyclohexanedimethylene terephthalate) (PCT), polyethylene naphthalate (PEN), polyamide (PA), polysulfone sulfonate (PSS), sulfonates of polysulfones, polyether ether ketone (PEEK), acrylonitrilebutadiene styrene (ABS), polyether ketone ketone (PEKK), polyphenylene sulfide (PPS), or blends or combinations thereof, more preferably the polymer matrix is a polymer selected from vinylidene fluoride (VDF) polymer.

8. The piezoelectric composite according to any one of claims 1-7, wherein the polymer matrix is a vinylidene fluoride (VDF) polymer selected from polyvinylidene fluoride (PVDF), polyvinylidene fluoride-co-tri-fluoroethylene (PVDF-TrFE), poly(vinylidene fluoride-co-hexafluoropropylene)(PVDF-HFP), polyvinylidene fluoride-co-tetrafluoro ethylene (PVDF-TFE), poly(vinylidene fluoride-co-trifluoroethylene-co-chlorofluoroethylene) (PVDF-TrFE-CFE), poly(vinylidene-fluoride-co-trifluoroethylene-co- chlorotrifluoroethylene)(PVDF-TfFE-CTFE) or combinations thereof, preferably the vinylidene fluoride (VDF) polymer is selected from poly(vinylidene fluoride-co-trifluoroethylene-co-chlorofluoroethylene) (PVDF-TrFE-CFE), or polyvinylidene fluoride-co-tri-fluoroethylene (PVDF-TrFE).

9. The piezoelectric composite according to any one of claims 1-8, wherein the piezoelectric composite comprises:
a. ≥ 20.0 volume % and ≤ 80.0 volume %, preferably ≥ 30.0 volume % and ≤ 55.0 volume %, with regard to the total volume of the piezoelectric composite, of the polymer matrix, wherein the polymer matrix comprises a polymer selected from poly(vinylidene fluoride-co-trifluoroethylene-co-chlorofluoroethylene) (PVDF-TrFE-CFE) or polyvinylidene fluoride- co-tri-fluoroethylene (PVDF-TrFE); and
b. ≥ 20.0 volume % and ≤ 80.0 volume %, preferably ≥ 30.0 volume % and ≤ 55.0 volume %, with regard to the total volume of the piezoelectric composite, of the plurality of coated piezoelectric filler particles dispersed in the polymer matrix, wherein each of the plurality of coated piezoelectric filler particles comprises a piezoelectric material comprising lithium doped potassium sodium niobate (KNLN) represented by the formula (K_{0.5}Na_{0.5})₁₋ₜLiₜNbO₃ wherein 't' is 0.03 (KNLN3) or 't' is 0.06 (KNLN6) and wherein each of the piezoelectric material is coated with a polymeric material selected from polyvinylpyrrolidone (PVP) or polydimethylsiloxane (PDMS).

10. A film comprising the piezoelectric composite according to any one of claims 1-9.

11. A method for preparing the film according to claim 10, wherein the method comprises:
a. dissolving a polymer in an organic solvent and forming a polymer solution;
b. adding a plurality of coated piezoelectric filler particles to the polymer solution and forming a precursor piezoelectric composite solution;
c. casting the precursor piezoelectric composite solution on a substrate and forming a precursor film; and
d. subjecting the precursor film to an electric polarization treatment and forming the film.

12. The method of claim 11, wherein the electric polarization treatment is conducted at an electric field ≥ 5 KV/mm and ≤ 100 KV/mm for a time period ≥ 1 minute and ≤ 120 minutes and at a temperature ≥ 50 °C and ≤ 120 °C.

13. An article of manufacture, such as a component of a touch panel or a human machine interface or an integrated keyboard or a wearable device, comprising the film according to claim 10.

14. Use of the film according to claim 10 for improving the piezoelectric property of the article of manufacture of claim 13.

## Patentansprüche

1. Piezoelektrischer Verbundstoff, umfassend:
a. eine Polymermatrix; und
b. eine Vielzahl von beschichteten piezoelektrischen Füllstoffpartikeln, wobei jedes der Vielzahl von beschichteten piezoelektrischen Füllstoffpartikeln in der Polymermatrix dispergiert ist, und ferner wobei jedes der Vielzahl von beschichteten piezoelektrischen Füllstoffpartikeln ein piezoelektrisches Material umfasst, aufweisend mindestens einen Abschnitt seiner Außenoberfläche, die mit einem Polymermaterial beschichtet ist, das mindestens eine polare funktionelle Gruppe aufweist, **dadurch gekennzeichnet, dass** die Polymermatrix und die Polymermaterialbeschichtung des piezoelektrischen Materials unterschiedliche Polymerzusammensetzungen aufweisen.

2. Piezoelektrischer Verbundstoff nach Anspruch 1, wobei das Polymermaterial mindestens eine polare funktionelle Gruppe umfasst, die ausgewählt ist aus einer Hydroxylgruppe, Carboxylatgruppe, Estergruppe, Sulfonsäuregruppe, Amidgruppe, Siloxangruppe, Aminogruppe, Sulfhydrylgruppe, Phosphatgruppe, Ethergruppe, Halogengruppe und einer Nitrilgruppe.

3. Piezoelektrischer Verbundstoff nach einem der Ansprüche 1 bis 2, wobei die Vielzahl von beschichteten piezoelektrischen Füllstoffpartikeln in einer Menge von ≥ 20,0 Volumen-% und ≤ 80,0 Volumen-%, bezogen auf das Gesamtvolumen des piezoelektrischen Verbundstoffs, vorhanden sind.

4. Piezoelektrischer Verbundstoff nach einem der Ansprüche 1 bis 3, wobei das piezoelektrische Material ausgewählt ist aus Hydroxylapatit, Apatit, Lithiumsulfat-Monohydrat, Natrium-Bismut-Titanat, Quarz, Weinsäure, Poly(vinylidendifluorid), Bariumtitanat, Kalium-Natrium-Niobat (KNaNb)O₃ (KNN), Blei-Zirkonat-Titanat (PZT), Blei-Niob-Titanat (PNT), Blei-Scandium-Niob-Titanat (PSNT), Blei-Metaniobat, mit Lithium dotiertem Kalium-Natrium-Niobat (KNLN), dargestellt durch die Formel (K_{0.5}Na_{0.5})₁₋ₜLiₜNbO₃ wobei die Variable "t" in dem Bereich von größer als 0,01 bis kleiner als 1,0 (0,01<t<1,00) liegt.

5. Piezoelektrischer Verbundstoff nach einem der Ansprüche 1 bis 4, wobei das Polymermaterial ausgewählt ist aus Polydimethylsiloxan (PDMS), Polyvinylpyrrolidon (PVP), gepfropften Polyolefinen, Acrylat- und Methacrylatpolymeren, Polyethylenglykol, Vinylacetatpolymeren, Polycarbonat, Vinylidenfluoridpolymeren (VDF-Polymeren), Cyanopolymeren, Poly(phenylenoxid) oder Kombinationen davon, vorzugsweise wobei das Polymermaterial ausgewählt ist aus Polydimethylsiloxan (PDMS), Polyvinylpyrrolidon (PVP), gepfropften Polyolefinen, Polyethylenglykol, Vinylacetatpolymeren, Cyanopolymeren oder Kombinationen davon; mehr bevorzugt, wobei das Polymermaterial ausgewählt ist aus Polydimethylsiloxan (PDMS) oder Polyvinylpyrrolidon (PVP).

6. Piezoelektrischer Verbundstoff nach einem der Ansprüche 1 bis 5, wobei das Polymermaterial ausgewählt ist aus Polyvinylpyrrolidon (PVP) oder Polydimethylsiloxan (PDMS) und das piezoelektrische Material ein mit Lithium dotiertes Kaliumnatriumniobat (KNLN) ist, dargestellt durch die Formel (K_{0.5}Na_{0.5})₁₋ₜLiₜNbO₃, wobei "t" 0,03 (KNLN3) ist oder "t" 0,06 (KNLN6) ist.

7. Piezoelektrischer Verbundwerkstoff nach einem der Ansprüche 1 bis 6, wobei die Polymermatrix ein Polymer ist, ausgewählt aus Vinylidenfluoridpolymer (VDF-Polymer), Polycaprolacton, Polysiloxan, Polydimethylsiloxan (PDMS), Polyolefin-Copolymeren, Polysiloxan-Polycarbonat-Copolymeren, Acrylat- und/oder Methacrylat-Copolymeren, Polyethylenterephthalat (PET), Polycarbonat (PC), Polybutylenterephthalat (PBT), Poly(1,4-cyclohexylidencyclohexan-1,4-dicarboxylat) (PCCD), glykolmodifiziertem Polycyclohexylterephthalat (PCTG), Poly(phenylenoxid) (PPO), Polypropylen (PP), Polyethylen (PE), Polyvinylchlorid (PVC), Polystyrol (PS), Polyethylenimin oder Polyetherimid (PEI) und deren Derivaten, thermoplastischem Elastomer (TPE), Terephthalsäurepolymeren (TPA-Polymeren), Poly(cyclohexandimethylenterephthalat) (PCT), Polyethylennaphthalat (PEN), Polyamid (PA), Polysulfonsulfonat (PSS), Sulfonate von Polysulfonen, Polyetheretherketon (PEEK), Acrylnitril-Butadien-Styrol (ABS), Polyetherketonketon (PEKK), Polyphenylensulfid (PPS) oder Mischungen oder Kombinationen davon, vorzugsweise die Polymermatrix ein Polymer ist, ausgewählt aus Vinylidenfluoridpolymer (VDF-Polymer), Polycaprolacton, Polyolefin-Copolymeren, Polysiloxan-Polycarbonat-Copolymeren, Acrylat- und/oder Methacrylat-Copolymeren, Polyethylenterephthalat (PET), Polycarbonat (PC), Polybutylenterephthalat (PBT), Poly(1,4-cyclohexylidencyclohexan-1,4-dicarboxylat) (PCCD), glykolmodifiziertem Polycyclohexylterephthalat (PCTG), Poly(phenylenoxid) (PPO), Polypropylen (PP), Polyethylen (PE), Polyvinylchlorid (PVC), Polystyrol (PS), Polyethylenimin oder Polyetherimid (PEI) und deren Derivate, Terephthalsäurepolymeren (TPA-Polymeren), Poly(cyclohexandimethylenterephthalat) (PCT), Polyethylennaphthalat (PEN), Polyamid (PA), Polysulfonsulfonat (PSS), Sulfonate von Polysulfonen, Polyetheretherketon (PEEK), Acrylnitril-Butadien-Styrol (ABS), Polyetherketonketon (PEKK), Polyphenylensulfid (PPS) oder Mischungen oder Kombinationen davon, mehr bevorzugt wobei die Polymermatrix ein Polymer ist, ausgewählt aus Vinylidenfluoridpolymer (VDF-Polymer).

8. Piezoelektrischer Verbundstoff nach einem der Ansprüche 1 bis 7, wobei die Polymermatrix ein Vinylidenfluoridpolymer (VDF-Polymer) ist, ausgewählt aus Polyvinylidenfluorid (PVDF), Polyvinylidenfluorid-co-tri-fluorethylen (PVDF-TrFE), Poly(vinylidenfluorid-co-hexafluorpropylen)(PVDF-HFP), Polyvinylidenfluorid-cotetrafluorethylen (PVDF-TFE), Poly(vinylidenfluorid-co-trifluorethylen-co-chlorfluorethylen) (PVDF-TrFE-CFE), Poly(vinylidenfluorid-co-trifluorethylen-co-chlortrifluorethylen) (PVDF-TfFE-CTFE) oder Kombinationen davon, vorzugsweise das
Vinylidenfluoridpolymer (VDF-Polymer) ausgewählt ist aus Poly(vinylidenfluorid-co-trifluorethylen-co-chlorfluorethylen) (PVDF-TrFE-CFE) oder Polyvinylidenfluorid-co-trifluorethylen (PVDF-TrFE).

9. Piezoelektrischer Verbundstoff nach einem der Ansprüche 1 bis 8, wobei der piezoelektrische Verbundstoff umfasst:
a. ≥ 20,0 Volumen-% und < 80,0 Volumen-%, vorzugsweise
≥ 30,0 Volumen-% und ≤ 55,0 Volumen-%, bezogen auf das Gesamtvolumen des piezoelektrischen Verbundstoffs der Polymermatrix, wobei die Polymermatrix ein Polymer ausgewählt aus Poly(vinylidenfluorid-co-trifluorethylen-co-chlorfluorethylen) (PVDF-TrFE-CFE) oder Polyvinylidenfluorid-co-trifluorethylen (PVDF-TrFE) umfasst; und
b. ≥ 20,0 Volumen-% und ≤ 80,0 Volumen-%, vorzugsweise
≥ 30,0 Volumen-% und ≤ 55,0 Volumen-%, bezogen auf das Gesamtvolumen des piezoelektrischen Verbundstoffs der Vielzahl von beschichteten piezoelektrischen Füllstoffpartikeln, die in der Polymermatrix dispergiert sind, wobei jedes der Vielzahl von beschichteten piezoelektrischen Füllstoffpartikeln ein piezoelektrisches Material umfasst, umfassend mit Lithium dotiertes Kaliumnatriumniobat (KNLN), dargestellt durch die Formel (K_{0.5}Na_{0.5})₁₋ₜLiₜNbO₃, wobei "t" 0,03 (KNLN3) ist oder "t" 0,06 (KNLN6) ist, und wobei jedes piezoelektrische Material mit einem Polymermaterial beschichtet ist, ausgewählt aus Polyvinylpyrrolidon (PVP) oder Polydimethylsiloxan (PDMS).

10. Folie, umfassend den piezoelektrischen Verbundstoff nach einem der Ansprüche 1 bis 9.

11. Verfahren zum Herstellen der Folie nach Anspruch 10, wobei das Verfahren umfasst:
a. Auflösen eines Polymers in einem organischen Lösungsmittel und Ausbilden einer Polymerlösung;
b. Hinzufügen einer Vielzahl von beschichteten piezoelektrischen Füllstoffpartikeln zu der Polymerlösung und Ausbilden einer Vorläuferlösung eines piezoelektrischen Verbundstoffs;
c. Gießen der Vorläuferlösung des piezoelektrischen Verbundstoffs auf ein Substrat und Ausbilden einer Vorläuferfolie; und
d. Unterziehen der Vorläuferfolie einer elektrischen Polarisationsbehandlung und Ausbilden der Folie.

12. Verfahren nach Anspruch 11, wobei die elektrische Polarisationsbehandlung bei einem elektrischen Feld ≥ 5 KV/mm und < 100 KV/mm für einen Zeitraum ≥ 1 Minute und ≤ 120 Minuten und bei einer Temperatur ≥ 50 °C und ≤ 120 °C durchgeführt wird.

13. Erzeugnis einer Herstellung, wie eine Komponente eines Touchpanels oder einer Mensch-Maschine-Schnittstelle oder einer integrierten Tastatur oder einer tragbaren Vorrichtung, umfassend die Folie nach Anspruch 10.

14. Verwendung der Folie nach Anspruch 10 zum Verbessern der piezoelektrischen Eigenschaft des Erzeugnisses der Herstellung nach Anspruch 13.

## Revendications

1. Composite piézoélectrique, comprenant :
a. une matrice polymère, et
b. une pluralité de particules de charge piézoélectrique enrobées, dans lequel chacune de la pluralité de particules de charge piézoélectrique enrobées est dispersée dans la matrice polymère, et dans lequel en outre chacune de la pluralité de particules de charge piézoélectrique enrobées comprend un matériau piézoélectrique dont au moins une partie de la surface extérieure est enrobée d'un matériau polymère ayant au moins un groupe fonctionnel polaire,
**caractérisé en ce que** la matrice polymère et l'enrobage du matériau polymère du matériau piézoélectrique sont de composition polymère différente.

2. Composite piézoélectrique selon la revendication 1, dans lequel le matériau polymère comprend au moins un groupe fonctionnel polaire choisi parmi le groupe hydroxyle, le groupe carboxylate, le groupe ester, le groupe acide sulfonique, le groupe amide, le groupe siloxane, le groupe amino, le groupe sulfhydryle, le groupe phosphate, le groupe éther, le groupe halogène, et un groupe nitrile.

3. Composite piézoélectrique selon l'une quelconque des revendications 1-2, dans lequel la pluralité de particules de charge piézoélectrique enrobées sont présentes dans une quantité ≥ 20,0 % en volume et ≤ 80,0 % en volume, par rapport au volume total du composite piézoélectrique.

4. Composite piézoélectrique selon l'une quelconque des revendications 1-3, dans lequel le matériau piézoélectrique est choisi parmi l'hydroxyapatite, l'apatite, le sulfate de lithium monohydraté, le titanate de bismuth sodique, le quartz, l'acide tartrique, le poly(difluorure de vinylidène), le titanate de baryum, le niobate de potassium et de sodium (KNaNb)O₃ (KNN), le titanate-zirconate de plomb (PZT), le titanate de plomb et de niobium (PNT), le titanate de plomb, de scandium et de niobium (PSNT), le métaniobate de plomb, le niobate de potassium-sodium dopé au lithium (KNLN), représenté par la formule (K_{0.5}Na_{0.5})₁₋ₜLiₜNbO₃, dans laquelle la variable « t » est comprise entre plus de 0,01 et moins de 1,0 (0,01<t<1,00).

5. Composite piézoélectrique selon l'une quelconque des revendications 1-4, dans lequel le matériau polymère est choisi parmi le polydiméthylsiloxane (PDMS), la polyvinylpyrrolidone (PVP), les polyoléfines greffées, les polymères d'acrylate et de méthacrylate, le polyéthylène glycol, les poly-acétate de vinyle polycarbonate, les polyfluorures de vinylidène (VDF), les polymères cyano, les poly(oxydes de phénylène) ou des combinaisons de ceux-ci, de préférence, le matériau polymère est choisi parmi le polydiméthylsiloxane (PDMS), la polyvinylpyrrolidone (PVP), les polyoléfines greffées, le polyéthylène glycol, les poly-acétates de vinyle, les polymères cyano, ou des combinaisons de ceux-ci ; plus préférablement, le matériau polymère est choisi parmi le polydiméthylsiloxane (PDMS) ou la polyvinylpyrrolidone (PVP).

6. Composite piézoélectrique selon l'une quelconque des revendications 1-5, dans lequel le matériau polymère est choisi parmi la polyvinylpyrrolidone (PVP) ou le polydiméthylsiloxane (PDMS) et le matériau piézoélectrique est un niobate de potassium-sodium dopé au lithium (KNLN) représenté par la formule (K_{0.5}Na_{0.5})₁₋ₜLiₜNbO₃ dans laquelle « t » est égal à 0,03 (KNLN3) ou « t » est égal à 0,06 (KNLN6).

7. Composite piézoélectrique selon l'une quelconque des revendications 1-6, dans lequel la matrice polymère est un polymère choisi parmi le polyfluorure de vinylidène (VDF), le polycaprolactone, le polysiloxane, le polydiméthylsiloxane (PDMS), les copolymères de polyoléfines, les copolymères polysiloxane-polycarbonate, les copolymères d'acrylate et/ou de méthacrylate, le polyéthylène téréphtalate (PET), le polycarbonate (PC), le polybutylène téréphtalate (PBT), le poly(I,4-cyclohexylidène cyclohexane-1,4-dicarboxylate) (PCCD), le polycyclohexyl téréphtalate modifié par le glycol (PCTG), le poly(oxyde de phénylène) (PPO), le polypropylène (PP), le polyéthylène (PE), le chlorure de polyvinyle (PVC), le polystyrène (PS), le polyéthylèneimine ou le polyétherimide (PEI) et leurs dérivés, l'élastomère thermoplastique (TPE), les polymères de l'acide téréphtalique (TPA), le poly(cyclohexanediméthylène téréphtalate) (PCT), le polyéthylène naphtalate (PEN), le polyamide (PA), le polysulfone sulfonate (PSS), les sulfonates de polysulfones, le polyéther éther cétone (PEEK), l'acrylonitrilebutadiène styrène (ABS), le polyéther cétone cétone (PEKK), le sulfure de polyphénylène (PPS), ou des mélanges ou des combinaisons de ceux-ci, de préférence la matrice polymère est un polymère choisi parmi le polymère de fluorure de vinylidène (VDF), le polycaprolactone, les copolymères de polyoléfine, les copolymères de polysiloxane et de polycarbonate, les copolymères d'acrylate et/ou de méthacrylate, le polyéthylène téréphtalate (PET), le polycarbonate (PC), le polybutylène téréphtalate (PBT), le poly(I,4-cyclohexylidène cyclohexane-I,4-dicarboxylate) (PCCD), le polycyclohexyl téréphtalate modifié par le glycol (PCTG), le poly(oxyde de phénylène) (PPO), le polypropylène (PP), le polyéthylène (PE), le polychlorure de vinyle (PVC), le polystyrène (PS), le polyéthylèneimine ou le polyétherimide (PEI) et leurs dérivés, les polymères de l'acide téréphtalique (TPA), le poly(cyclohexanediméthylène téréphtalate) (PCT), le polyéthylène naphtalate (PEN), le polyamide (PA), le polysulfone sulfonate (PSS), les sulfonates de polysulfones, le polyéther éther cétone (PEEK), l'acrylonitrilebutadiène styrène (ABS), le polyéther cétone cétone (PEKK), le sulfure de polyphénylène (PPS), ou des mélanges ou des combinaisons de ceux-ci, plus préférablement la matrice polymère est un polymère choisi parmi le polymère de fluorure de vinylidène (VDF).

8. Composite piézoélectrique selon l'une quelconque des revendications 1-7, dans lequel la matrice polymère est un polymère de fluorure de vinylidène (VDF) choisi parmi le fluorure de polyvinylidène (PVDF), le fluorure de polyvinylidène-co-tri-fluoroéthylène (PVDF-TrFE), le poly(fluorure de vinylidène-co-hexafluoropropylène)(PVDF-HFP), le fluorure de polyvinylidène-co-tétrafluoroéthylène (PVDF-TFE), le poly(fluorure de vinylidène-co-trifluoroéthylène-co- chlorofluoroéthylène)(PVDF-TrFE-CFE), le poly(fluorure de vinylidène-co-trifluoroéthylène-co- chlorotrifluoroéthylène)(PVDF-TfFE-CTFE) ou des combinaisons de ceux-ci, de préférence le
polymère de fluorure de vinylidène (VDF) est choisi parmi le poly(fluorure de vinylidène-co- trifluoroéthylène-co-chlorofluoroéthylène) (PVDF-TrFE-CFE), ou le polyfluorure de vinylidène-co-tri-fluoroéthylène (PVDF-TrFE).

9. Composite piézoélectrique selon l'une quelconque des revendications 1-8, dans lequel le composite piézoélectrique comprend :
a. ≥ 20,0 % en volume et ≤ 80,0 % en volume, de préférence ≥ 30,0 % en volume et ≤ 55,0 % en volume, par rapport au volume total du composite piézoélectrique, de la matrice polymère, dans lequel la matrice polymère comprend un polymère choisi parmi le poly(fluorure de vinylidène-co-trifluoroéthylène-co-chlorofluoroéthylène) (PVDF- TrFE-CFE) ou le polyfluorure de vinylidène - co-tri-fluoroéthylène (PVDF-TrFE) ; et
b. ≥ 20,0 % en volume et ≤ 80,0 % en volume, de préférence ≥ 30,0 % en volume et ≤ 55,0 % en volume, par rapport au volume total du composite piézoélectrique, de la pluralité de particules de charge piézoélectriques enrobées dispersées dans la matrice polymère, dans lequel chacune de la pluralité de particules de charge piézoélectriques enrobées comprend un matériau piézoélectrique comprenant du niobate de potassium-sodium dopé au lithium (KNLN) représenté par la formule (K_{0.5}Na_{0.5})₁₋ₜLiₜNbO₃, dans laquelle « t » est égal à 0,03 (KNLN3) ou « t » est égal à 0,06 (KNLN6) et dans laquelle chaque matériau piézoélectrique est enrobé d'un matériau polymère choisi parmi la polyvinylpyrrolidone (PVP) ou le polydiméthylsiloxane (PDMS).

10. Film comprenant le composite piézoélectrique selon l'une quelconque des revendications 1-9.

11. Procédé de préparation du film selon la revendication 10, dans lequel le procédé comprend :
a. la dissolution d'un polymère dans un solvant organique et la formation d'une solution de polymère ;
b. l'ajout d'une pluralité de particules de charge piézoélectrique enrobées à la solution de polymère et la formation d'une solution composite piézoélectrique précurseur ;
c. la coulée de la solution composite piézoélectrique précurseur sur un substrat et la formation d'un film précurseur ; et
d. la soumission du film précurseur à un traitement de polarisation électrique et la formation du film.

12. Procédé selon la revendication 11, dans lequel le traitement par polarisation électrique est conduit à un champ électrique ≥ 5 KV/mm et ≤ 100 KV/mm pendant un laps de temps ≥ 1 minute et ≤ 120 minutes et à une température ≥ 50 °C et ≤ 120 °C.

13. Article manufacturé, tel qu'un composant d'un panneau tactile ou d'une interface homme-machine ou d'un clavier intégré ou d'un dispositif portable, comprenant le film selon la revendication 10.

14. Utilisation du film selon la revendication 10 pour améliorer la propriété piézoélectrique de l'article manufacturé selon la revendication 13.
